# EUROPEAN PATENT SPECIFICATION

(11) **EP 0 686 980 B1**
(45) Date of publication and mention of the grant of the patent: **16.12.1998**
(21) Application number: 95111838.9
(22) Date of filing: 30.01.1990
(51) Int. Cl.: G11C 29/00, G06F 11/20, G11C 11/00

(54) **Semiconductor memory device having means for replacing defective memory cells**
Halbleiterspeicher mit Einrichtung zum Ersetzen defekter Speicherzellen
Mémoire à semi-conducteur avec dispositif pour substituer les éléments défectueux

(30) Priority: 31.01.1989 JP 21337/89; 09.02.1989 JP 30435/89; 09.02.1989 JP 30436/89; 10.02.1989 JP 31562/89; 10.02.1989 JP 31561/89; 10.02.1989 JP 31484/89
(43) Date of publication of application: 13.12.1995
(62) Divisional of application: 90300935.5
(73) Proprietor: FUJITSU LIMITED, Kawasaki-shi, Kanagawa 211 (JP); FUJITSU VLSI LIMITED, Kasugai-shi Aichi 487 (JP)
(72) Inventor: Kasa, Yasushi, c/o Fujitsu Limited, Kawasaki-shi, Kanagawa 211 (JP); Takemae, Yoshihiro, c/o Fujitsu Limited, Kawasaki-shi, Kanagawa 211 (JP); Nagasawa, Masanori, c/o Fujitsu Limited, Kawasaki-shi, Kanagawa 211 (JP); Arayama, Yuji, c/o Fujitsu Limited, Kawasaki-shi, Kanagawa 211 (JP); Terui, Akira, c/o Fujitsu Limited, Kawasaki-shi, Kanagawa 211 (JP); Araki, Sunao c/o Fujitsu Ltd.,, Kawasaki-shi, Kanagawa 211 (JP)
(74) Representative: Stebbing, Timothy Charles

(56) References cited:
- EP-A- 0 031 386
- EP-A- 0 333 207
- DE-A- 3 906 897
- US-A- 4 564 924

## Description

The present invention generally relates to semiconductor memory devices, and more particularly to a semiconductor memory device such as a mask read only memory (ROM) which is capable of replacing defective memory cells.

Data written in a mask ROM is fixed during the production process when an exposure is made using a photomask or an exposure is made directly without the use of the photomask. The mask ROM is suited for use in a case where there is a need to produce a large number of ROMs which store identical fixed data such as character font data. In addition, the memory cell structure of the mask ROM is simple and the size of the memory cells can easily be reduced. For this reason, the design rule is reduced and the chip size is increased recently to further improve the integration density.

On the other hand, defective memory cells increase as the integration density becomes high. As a result, there are problems in that the yield of the mask ROM becomes poor and the mask ROM becomes expensive.

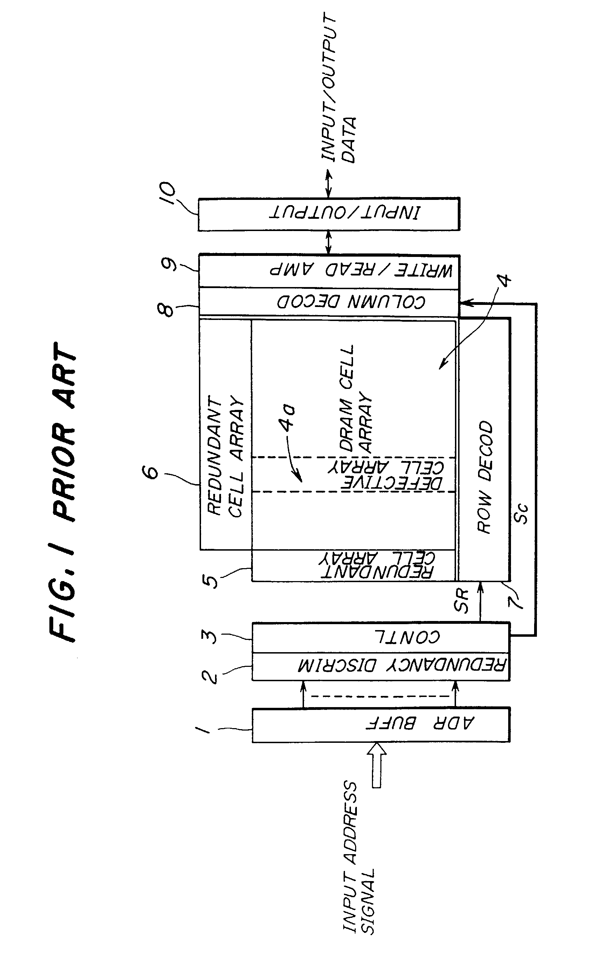

Conventionally, there are methods of replacing the defective memory cells by using the so-called redundant memory cells in place of the defective memory cells, and these methods are generally employed in a dynamic random access memory (DRAM), a static RAM (SRAM) and an erasable programmable ROM (EPROM). FIG.1 shows an essential part of an example of the DRAM which employs such a conventional method of replacing the defective memory cells.

In FIG.1, the DRAM comprises an address buffer 1, a redundancy discriminating circuit 2, a control circuit 3, a DRAM memory cell array 4, a defective memory cell array 4a which includes defective memory cells and corresponds to one row, for example, a redundant memory cell array 5 which corresponds to one row, a redundant memory cell array 6 which corresponds to one column, a row decoder 7, a column decoder 8, a write/read amplifier 9, and an input/output circuit 10.

The redundancy discriminating circuit 2 detects whether or not an input address coincides with a preset redundant address of the defective memory cell array 4a, and makes the control circuit 3 output a control signal S_{R} or S_{C} when the input address coincides with the redundant address. It will be assumed for the sake of convenience that the control circuit 3 outputs the control signal S_{R}, that is, the defective memory cell array 4a is substituted by the redundant memory cell array 5. In this case, the write/read amplifier 9 writes data in or reads data from the redundant memory cell array 5. In other words, the defective memory cells corresponding to one row is substituted by the redundant memory cells to relieve the defective memory cells, thereby improving the yield of the DRAM.

However, this method of replacing the defective memory cells of the DRAM cannot be applied to the mask ROM because the fixed data are written into the mask ROM during the production process. In the case of the mask ROM, the fixed data cannot be written into the redundant memory cells after the defective memory cells are found. In order to overcome this problem, it is conceivable to use redundant memory cells having a PROM structure. In this conceivable case, it is possible to freely write the fixed data into the redundant memory cells having the PROM structure after the defective memory cells are found.

The yield of the mask ROM can be improved according to the above conceivable method which uses the redundant memory cells having the PROM structure. But on the other hand, the integration density of the mask ROM becomes poor for the following reason. That is, the cell area of the mask ROM versus the cell area of the PROM is generally in the order of 1:30, and the cell area of the PROM is extremely large compared to that of the mask ROM. For this reason, when word lines and bit lines are used in common between the mask ROM and the PROM and the mask ROM and the PROM coexist on the chip, the integration density of the mask ROM becomes determined by the cell area of the PROM. As a result, there are problems in that the advantageous features of the mask ROM cannot be utilized and the integration density of the mask ROM becomes poor.

EP-A-0 333 207 falls under Article 54(3) EPC and discloses a mask ROM with a spare (redundant) memory cell group arranged apart from the main ROM cell array. The spare memory cell group uses bit lines or word lines different from those of the main array and includes memory cells different in structure from those of the main array. When a row or column including a defective cell is designated in the main array, a row or column of cells in the spare group is activated.

EP-A-0 031 386 discloses a RAM or ROM having a main memory cell array selected by two decoders and a redundant memory cell array selected by two decoders, one of which is dedicated to the redundant array. When the redundant array is selected by this dedicated decoder, a decoder of the main array is not precharged and therefore does not operate even when it receives address information for a cell in the main array.

US-A-4 564 924 discloses a memory device with redundant cells, in which the redundant cells are disposed in rows and/or column at the edges of the main cell array, spaced apart from each other and from the main array at greater than normal row or column spacing.

According to the present invention, there is provided a semiconductor memory device which comprises:
a memory cell array having a plurality of blocks each including a plurality of rows and columns;
a redundant cell array having redundant cells which may replace defective memory cells within the memory cell array;
a defective address memory for storing a defective address of a block which includes a defective memory cell;
an operation means for carrying out an operation with respect to the defective address and a predetermined quantity and for outputting an address as an operation result; and
selection means for comparing the defective address and the output address of said operation means with an input address, and for selecting a redundant cell within the redundant cell array in place of the defective cell within the memory cell array when one of the defective address and the output address of said operation means matches the input address.

Reference is made, by way of example, to the accompanying drawings in which:
FIG. 1 is a system block diagram showing an essential part of an example of a conventional DRAM having means for replacing defective memory cells;
FIG.2 is a system block diagram showing an example of a conventional SRAM for facilitating the understanding of the semiconductor memory device according to the present invention;
FIG.3 is a diagram showing an address structure;
FIGS.4 through 6 are diagrams for explaining replacement of defective portions within the SRAM shown in FIG.2;
FIG.7 is a system block diagram showing a conceivable SRAM for facilitating the understanding of the present invention;
FIG.8 is a diagram showing an address structure;
FIGS. 9 and 10 are diagrams for explaining replacement of defective portions within the SRAM shown in FIG.7;
FIG.11 is a system block diagram showing an essential part of a device embodying the present invention; and
FIGS. 12A, 12B, 12C and 13 respectively are diagrams for explaining replacement of defective portions within the device of FIG.11.

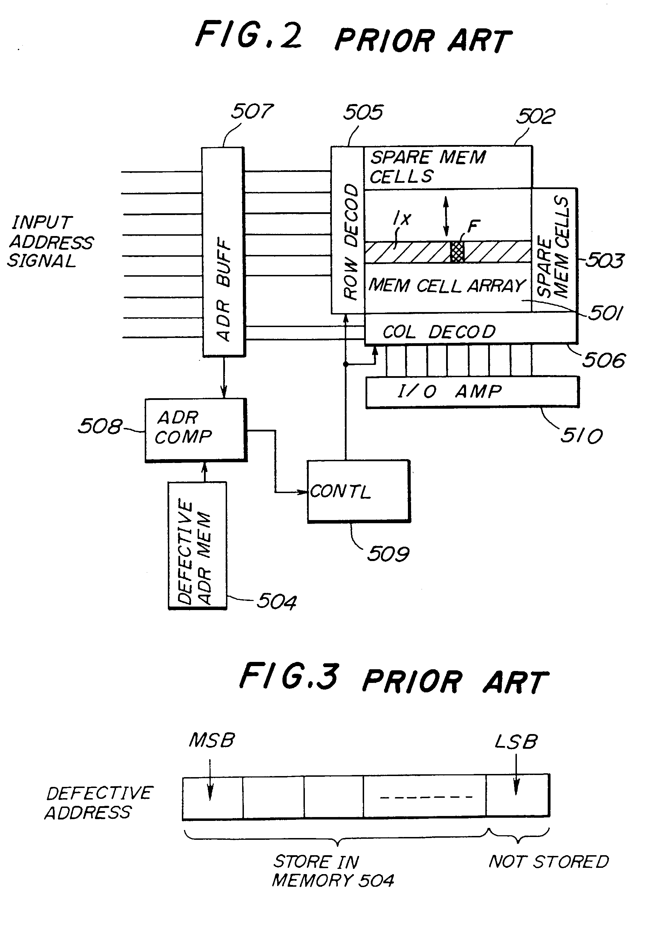

First, a description will be given of a conventional SRAM for facilitating the understanding of the semiconductor memory device according to the present invention. FIG. 2 shows an example of the conventional SRAM in which a memory cell array 501 comprises a plurality of memory cells located at intersections of word lines and bit lines. Spare memory cells 502 are arranged along the word lines adjacent to the memory cell array 501, and spare memory cells 503 are arranged along the bit lines adjacent to the memory cell array 501. The defective memory cell is replaced in units of one row or line, and the spare memory cells 502 and 503 respectively have memory cells amounting to several spare lines. A defective line 1x which includes a defective memory cell F is replaced by a spare line by registering a defective address of the memory cell array 501 into a defective address memory 504.

The word lines of the memory cell array 501 and the word lines of the spare memory cells 502 are respectively connected to a row decoder 505. Similarly, the bit lines of the memory cell array 501 and the bit lines of the spare memory cells 503 are respectively connected to a column decoder 506. When an input address signal is supplied to an address buffer 507, this input address signal is supplied to a comparing circuit 508 wherein the input address is compared with the defective address which is registered in the defective address memory 504. The comparing circuit 508 supplies a coincidence signal to a control circuit 509 when the two compared addresses coincide.

Based on the coincidence signal, the control circuit 509 generates a decoded signal for replacing the defective line 1x by the lines of the spare memory cells 502 and 503. The decoded signal is supplied to the row decoder 505 and the column decoder 506. Accordingly, the defective word line or bit line of the memory cell array 501 is replaced by the line of the spare memory cells 502 or 503, and the data of the replaced line is output via an input/output amplifier 510. When no defective memory cell F exists in the memory cell array 501, the input address is decoded normally and the data is read out from the memory cell array 501.

However, the defective address memory 504 stores the defective address which designates the word lines or bit lines in units of blocks (or pairs). For this reason, the least significant bit (LSB) of the address which has an address structure shown in FIG.3 is not stored in the defective address memory 508. Therefore, when the defective portion of the memory cell array 501 spans two blocks, it is impossible to replace the defective memory cells and the reliability of the data deteriorates.

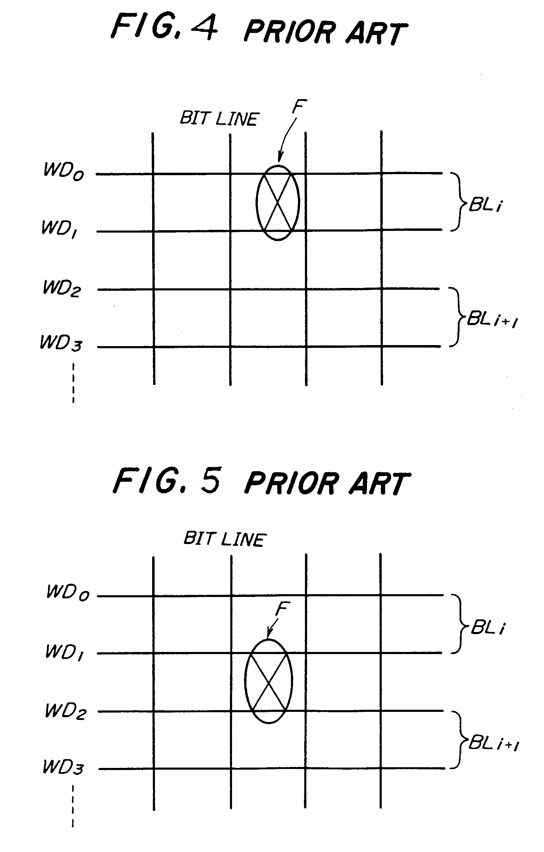

For example, memory cell array 501 comprises word lines WD0 through WD3 as shown in FIG.4. If a defective portion F exists in a block BLi which is made up of the word lines WD0 and WD1, this defective portion F can be cured by use of the defective address which is stored in the defective address memory 504 even though the defective address does not include the LSB, because the defective portion F exists within the block BLi.

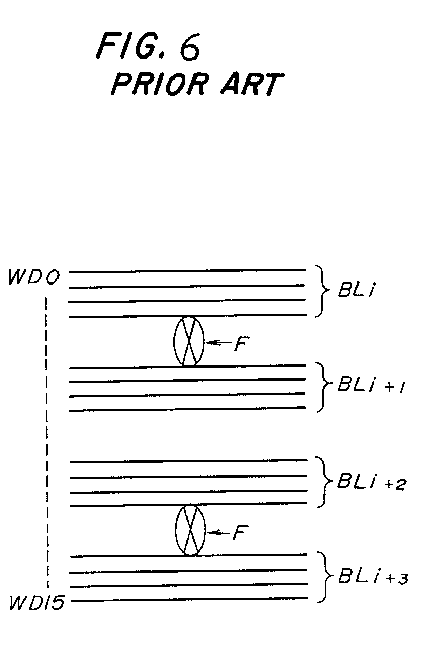

But when the defective portion F spans two blocks BLi and BLi+1 as shown in FIG. 5, the detective portion F cannot be cured by use of the defective address which only designates the defective portion F in terms of one block. Similarly, when each block is made up of four word lines and the defective portion F spans four blocks BLi, BLi+1, BLi+2 and BLi+3 as shown in FIG. 6, it is also impossible to cure the defective portion F.

Conventionally, the replacement of the defective portion is carried out in blocks by use of the redundant circuit in order to maintain a practical level. But recently, there are demands to realize a higher yield, and it is becoming necessary to cure the defective portion which spans two blocks made up of the word lines or the bit lines.

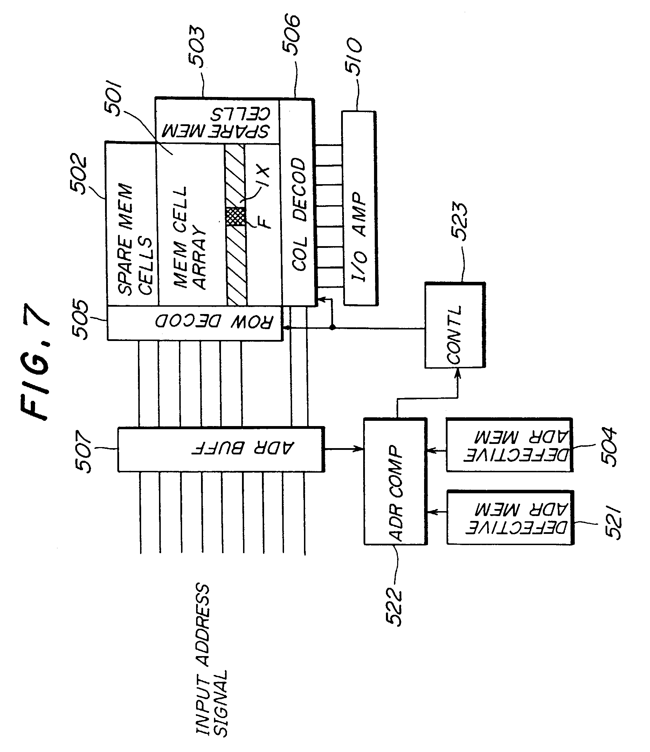

In order to cure the defective portion which spans two blocks, a SRAM shown in FIG. 7 is conceivable. In FIG. 7, those parts which are essentially the same as those corresponding parts in FIG. 2 are designated by the same reference numerals, and a description thereof will be omitted. In FIG.7, a second defective address memory 521 is provided to store the LSB of the defective address, and the redundant process is carried out based on the information stored in the second defective address memory 521.

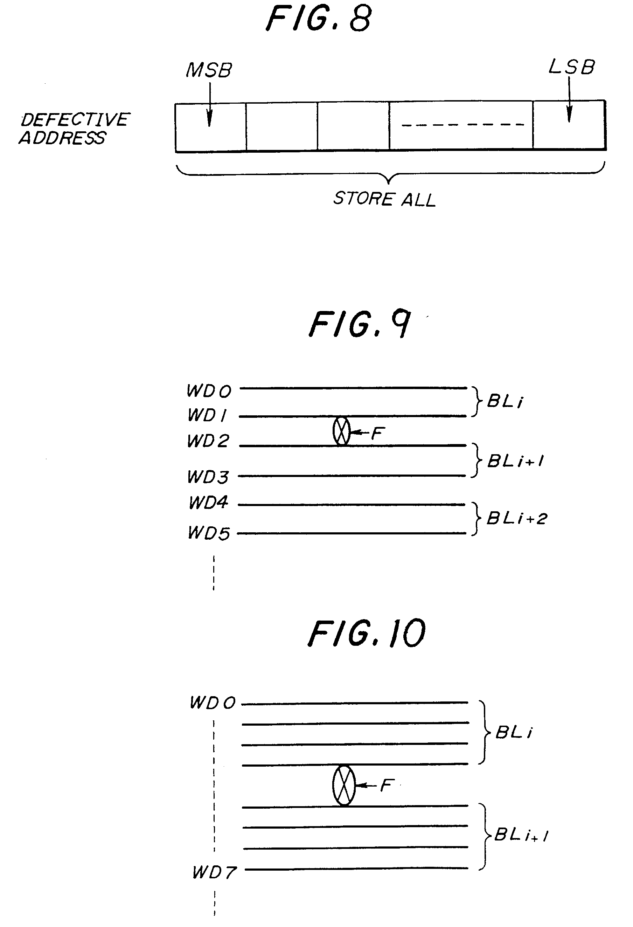

All of the bits including the LSB of the defective address shown in FIG. 8 are stored by the defective address memories 504 and 521, and it is possible to designate one word line or bit line within the memory cell array 501. Outputs of the defective address memories 504 and 521 are supplied to an address comparing circuit 522, and the address comparing circuit 522 supplies a coincidence signal to a control circuit 523 when all bits of the input address coincide with the corresponding bits of the defective address. Based on the coincidence signal, the control circuit 523 generates a decoded signal for replacing the defective line 1x by the line of the spare memory cells 502 or 503. The decoded signal is supplied to the row decoder 505 and the column decoder 506.

When the defective portion F spans the word lines WD1 and WD2 of the memory cell array 501 as shown in FIG. 9, all bits of the addresses of the word lines WD1 and WD2 are respectively stored in the defective address memories 504 and 521. The address comparing circuit 522 outputs the coincidence signal to the control circuit 523 when the input address coincides with the address of the word line WD1 or WD2, and the data from the word line WD1 or WD2 is replaced by the data from the line of the spare memory cells 502.

When the defective portion F spans two blocks BLi and BLi+1, this defective portion F cannot be cured by the conventional SRAM shown in FIG.2 as described before in conjunction with FIG.5. But according to the conceivable SRAM shown in FIG. 7, each of the word lines WD1 and WD2 can be specified and replaced by the line of the spare memory cells 502 because all bits of the defective address are stored. Hence, the conceivable SRAM can cure the defective portion F which spans two blocks BLi and BLi+1 such as a case where the two blocks BLi and BLi+1 are short-circuited.

However, even in the case of the conceivable SRAM, the defective portion F between four blocks BLi, BLi+1, BLi+2 and BLi+3 (only BLi and BLi+1 shown) shown in FIG.10 cannot be cured when each block is made up of four word lines, for example.

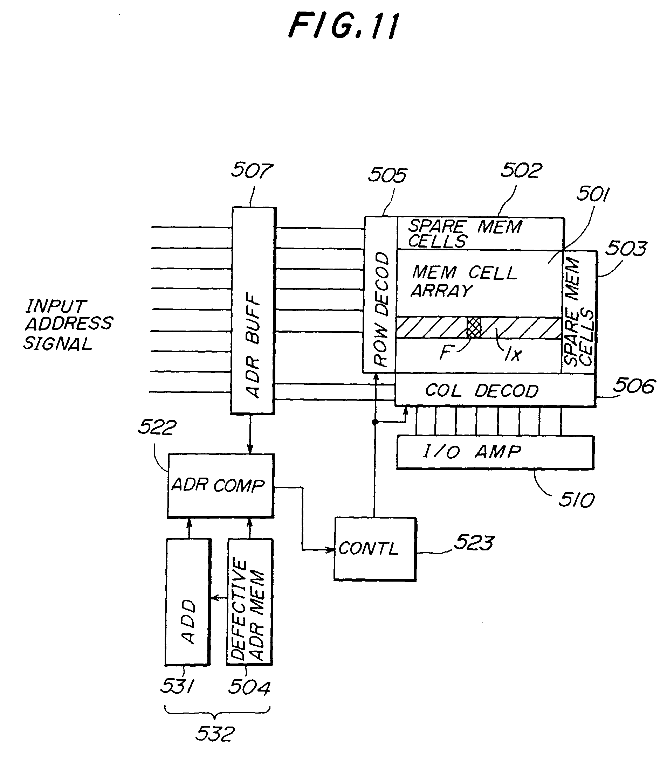

Next, a description will be given of an embodiment of the semiconductor memory device according to the present invention, in which the above described problems are eliminated. FIG. 11 shows an essential part of the embodiment. In FIG. 11, those parts which are essentially the same as those corresponding parts in FIG.2 are designated by the same reference numerals, and a description thereof will be omitted.

In this embodiment, an adder 531 is provided as shown in FIG. 11. This adder 531 increments the address which is stored in the defective address memory 504 and supplies the incremented address to the address comparing circuit 522. The address comparing circuit 522 supplies a coincidence signal to the control circuit 523 when the input address coincides with either one of the addresses received from the defective address memory 504 and the adder 531. The control circuit 523 generates a control signal responsive to the coincidence signal so that the defective line 1x is replaced by the line of the spare memory cells 502 or 503.

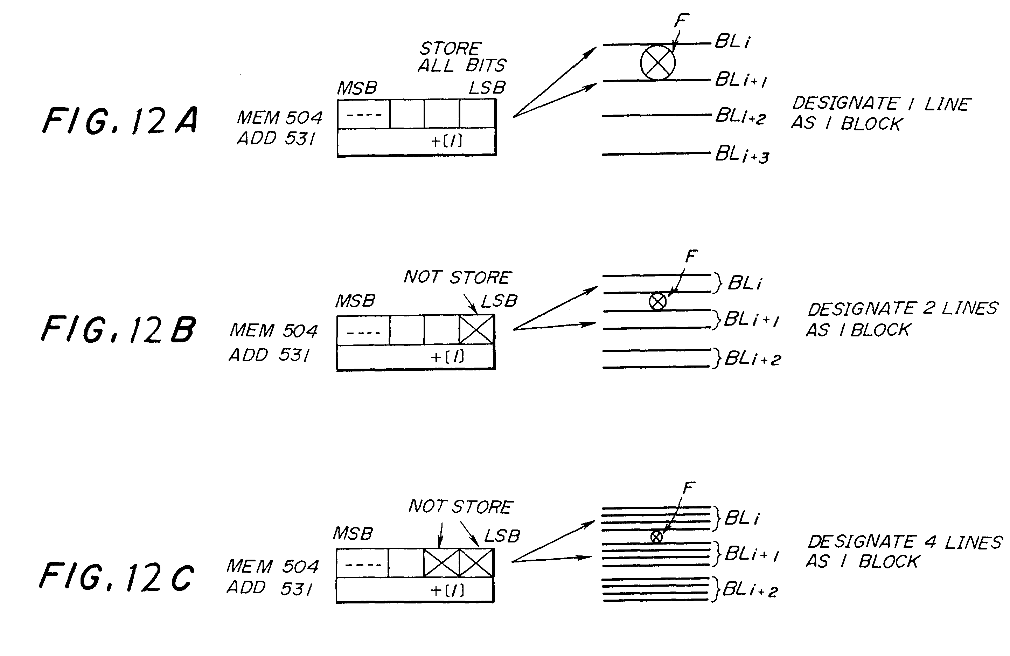

By storing all bits of the defective address in the defective address memory 504 as shown in FIG. 12A it is possible to replace the defective portion by taking one line as one block. In addition, when two lines are designated as one block as shown in FIG.12B and the address is incremented by the adder 531, it is possible to replace the defective portion which spans two blocks. Similarly, when four lines are designated as one block and the address incremented as shown in FIG.12C, it is possible to replace the defective portion which spans two blocks.

Therefore, when one or a plurality of lines are designated as one block by the defective address memory 504 and another block is designated by the adder 531, it is not only possible to replace the defective portion within the block but also replace the defective portion which spans two blocks. Furthermore, the adder 531 is not limited to incrementing the address by one but may add an arbitrary integer n to the address.

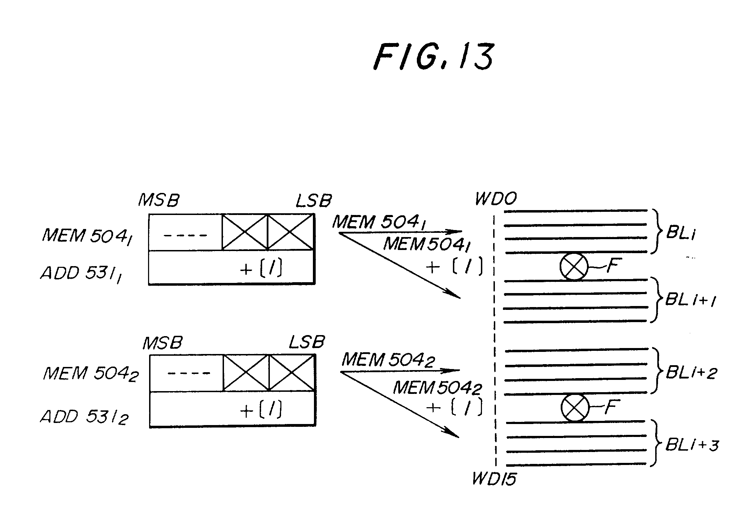

When eliminating the problem described before in conjunction with FIG.10, the defective address memory 504 designates a block which comprises four lines and the adder 531 designates a block which also comprises four lines by incrementing the address stored in the defective address memory 504, as shown in FIG. 13. In FIG.13, the defective address memory 504 is shown as memory parts 504₁ and 504₂ and the adder 531 is shown as adder parts 531₁ and 531₂ for the sake of convenience to illustrate parts which respectively designate the two blocks.

According to this embodiment, it is possible to designate other blocks when one block is designated. The defective portion can be replaced positively even when the defective portion spans four blocks, for example. Further, the bit line defects can be cured similarly although the description above only describes curing the word line defects.

In addition, the application of this embodiment is not limited to the SRAM and is applicable to any type of memory which has a redundant structure. For example, this embodiment is applicable to the DRAM, EPROM, and mask ROM. Of course, in the case of the mask ROM, a decoding system provided with respect to the spare memory cells is independent of the decoding system provided with respect to the normal memory cells.

## Claims

1. A semiconductor memory device which comprises:
a memory cell array (501) having a plurality of blocks each including a plurality of rows and columns;
a redundant cell array (502,503) having redundant cells which may replace defective memory cells within the memory cell array (501);
a defective address memory (504) for storing a defective address of a block which includes a defective memory cell;
an operation means (522,523,531) for carrying out an operation with respect to the defective address and a predetermined quantity and for outputting an address as an operation result; and
selection means (506) for comparing the defective address and the output address of said operation means with an input address, and for selecting a redundant cell within the redundant cell array in place of the defective cell within the memory cell array when one of the defective address and the output address of said operation means matches the input address.

2. The semiconductor memory device as claimed in claim 1, wherein said operation means (522,523,531) includes adding means (531) for adding an integer L as said predetermined quantity to the redundant address stored in said defective address memory means (504), and comparing means (522) for outputting a discrimination signal when the input address coincides with one of the addresses received from said adding means and said defective address memory (504).

3. The semiconductor memory device as claimed in claim 2, wherein the addresses which are output from said defective address memory (504) and said adding means (531) respectively designate one block, each block being made up of one or more rows of said memory cell array (501).

4. The semiconductor memory device as claimed in claim 2, wherein the addresses which are output from said defective address memory (504) and said adding means (531) respectively designate one block, each block being made up of one or more columns of said memory cell array (501).

5. The semiconductor memory device as claimed in any of claims 1 to 4, wherein said memory cell array (501) is selected from a group which includes a dynamic random access memory, an erasable programmable read only memory and a mask read only memory.

6. The semiconductor memory device as claimed in any of claims 1 to 5, wherein said memory cell array (501) comprises memory cells for prestoring fixed data, and wherein said redundant cell array (502, 503) comprises programmable non-volatile memory cells.

7. The semiconductor memory device as claimed in claim 6, wherein the defective address stored in said defective address memory (504) is a portion of the address of each defective memory cell of said memory cell array (501).

8. The semiconductor memory device as claimed in claim 7, wherein said selecting means (506) replaces the data read out from said memory cell array (501) by the data from at least one of a corresponding row and column of said redundant cell array (502,503) when the defective address spans two adjacent rows or columns of said memory cell array (501) and the discrimination signal is received from said discriminating means (522,523,531), and wherein the addresses which are output from said defective address memory (504) and said adding means (531) respectively designate one block, each block being made up of one or a plurality of rows or columns of said memory cell array (501).

## Patentansprüche

1. Halbleiterspeichervorrichtung, enthaltend:
ein Speicherzellen-Array (501), das eine Vielzahl von Blöcken hat, die jeweils eine Vielzahl von Reihen und Spalten enthalten;
ein Redundanzzellen-Array (502, 503), das Redundanzzellen hat, die fehlerhafte Speicherzellen innerhalb des Speicherzellen-Array (501) ersetzen können;
einen Speicher (504) für fehlerhafte Adressen zum Speichern einer fehlerhaften Adresse eines Blockes, der eine fehlerhafte Speicherzelle enthält;
eine Operationseinrichtung (522, 523, 531) zum Ausführen einers Operation bezüglich der fehlerhaften Adresse und einer vorbestimmten Menge und zum Ausgeben einer Adresse als ein Operationsergebnis; und
eine Auswähleinrichtung (506) zum Vergleichen der fehlerhaften Adresse und der Ausgabeadresse der Operationseinrichtung mit einer Eingabeadresse und zum Auswählen einer Redundanzzelle innerhalb des Redundanzzellen-Array anstelle der fehlerhaften Zelle innerhalb des Speicherzellen-Array, wenn entweder die fehlerhafte Adresse oder die Ausgabeadresse der Operationseinrichtung mit der Eingabeadresse übereinstimmen.

2. Halbleiterspeichervorrichtung nach Anspruch 1, bei welcher die Operationseinrichtung (522, 523, 531) eine Addiereinrichtung (531) zum Addieren einer ganzen Zahl (L) als die vorbestimmte Größe zu der Redundanzadresse, die in der Speichereinrichtung (504) für fehlerhafte Adressen gespeichert ist, sowie eine Vergleichseinrichtung (522) zum Ausgeben eines Unterscheidungssignals, wenn die eingegebene Adresse mit einer der Adressen übereinstimmt, die von der Addiereinrichtung oder von dem Speicher (504) für fehlerhafte Adressen empfangen wird, enthält.

3. Halbleiterspeichervorrichtung nach Anspruch 2, bei welcher die Adressen, die von dem Speicher (540) für fehlerhafte Adressen und der Addiereinrichtung (531) ausgegeben werden, jeweils einen Block bezeichnen, wobei jeder Block aus einer oder mehreren Reihen des Speicherzellen-Array (501) besteht.

4. Halbleiterspeichervorrichtung nach Anspruch 2, bei welcher die Adressen, die von dem Speicher (504) für fehlerhafte Adressen und der Addiereinrichtung (531) ausgegeben werden, jeweils einen Block bezeichnen, wobei jeder Block aus einer oder mehreren Spalten des Speicherzellen-Array (501) besteht.

5. Halbleiterspeichervorrichtung nach einem der Ansprüche 1 bis 4, bei welcher das Speicherzellen-Array (501) ausgewählt ist aus einer Gruppe, die einen dynamischen Direktzugriffsspeicher, einen löschbaren programmierbaren Nurlesespeicher und einen Masken-Nurlesespeicher enthält.

6. Halbleiterspeichervorrichtung nach einem der Ansprüche 1 bis 5, bei welcher das Speicherzellen-Array (501) Speicherzellen zum Speichern von festgelegten Daten im voraus enthält, und bei welcher das Redundanzzellen-Array (502, 503) programmierbare nichtflüchtige Speicherzellen enthält.

7. Halbleiterspeichervorrichtung nach Anspruch 6, bei welcher die fehlerhafte Adresse, die in dem Speicher (504) für fehlerhafte Adressen gespeichert ist, ein Teil der Adresse jeder fehlerhaften Speicherzelle des Speicherzellen-Array (501) ist.

8. Halbleiterspeichervorrichtung nach Anspruch 7, bei welcher die Auswähleinrichtung (506) die aus dem Speicherzellen-Array (501) ausgelesenen Daten durch die Daten aus mindestens einer von einer entsprechenden Reihe und Spalte des Redundanzzellen-Array (502, 503) ersetzt, wenn die fehlerhafte Adresse zwei benachbarte Reihen oder Spalten des Speicherzellen-Array (501) überspannt und das Unterscheidungssignal von der Unterscheidungseinrichtung (522, 523, 531) empfangen wird, und bei welcher die Adressen, die von dem Speicher (504) für fehlerhafte Adressen und dem Addiereinrichtung (531) ausgegeben werden, jeweils einen Block bezeichnen, wobei jeder Block aus einer oder einer Vielzahl von Reihen oder Spalten des Speicherzellen-Array (501) besteht.

## Revendications

1. Dispositif de mémoire à semi-conducteur qui comprend :
un réseau de cellules de mémoire (501) ayant une pluralité de blocs comprenant chacun une pluralité de rangées et de colonnes ;
un réseau de cellules redondantes (502, 503) ayant des cellules redondantes qui peuvent remplacer des cellules de mémoire défectueuses dans le réseau de cellules de mémoire (501) ;
une mémoire d'adresse défectueuse (504) pour stocker une adresse défectueuse d'un bloc qui comprend une cellule de mémoire défectueuse ;
un moyen d'opération (522, 523, 531) pour réaliser une opération par rapport à l'adresse défectueuse et une quantité prédéterminée et pour fournir une adresse comme un résultat d'opération ; et
un moyen de sélection (506) pour comparer l'adresse défectueuse et l'adresse de sortie dudit moyen d'opération avec une adresse d'entrée, et pour sélectionner une cellule redondante dans le réseau de cellules redondantes à la place de la cellule défectueuse dans le réseau de cellules de mémoire lorsqu'une des adresses défectueuses et l'adresse de sortie dudit moyen d'opération correspondent à l'adresse d'entrée.

2. Dispositif de mémoire à semi-conducteur selon la revendication 1, dans lequel ledit moyen d'opération (522, 523, 531) comprend un moyen d'addition (531) pour additionner un entier L comme ladite quantité prédéterminée à l'adresse redondante stockée dans ledit moyen de mémoire d'adresse défectueuse (504), et un moyen de comparaison (522) pour fournir un signal de discrimination lorsque l'adresse d'entrée coïncide avec une des adresses reçues dudit moyen d'addition et ladite mémoire d'adresse défectueuse (504).

3. Dispositif de mémoire à semi-conducteur selon la revendication 2, dans lequel les adresses qui sont fournies par ladite mémoire d'adresse défectueuse (504) et ledit moyen d'addition (531) désignent respectivement un bloc, chaque bloc étant constitué d'une ou de plusieurs rangées dudit réseau de cellules de mémoire (501).

4. Dispositif de mémoire à semi-conducteur selon la revendication 2, dans lequel les adresses qui sont fournies par ladite mémoire d'adresses défectueuses (504) et ledit moyen d'addition (531) désignent respectivement un bloc, chaque bloc étant constitué d'une ou de plusieurs colonnes dudit réseau de cellules de mémoire (501).

5. Dispositif de mémoire à semi-conducteur selon l'une quelconque des revendications 1 à 4, dans lequel ledit réseau de cellules de mémoire (501) est sélectionné à partir d'un groupe qui comprend une mémoire RAM dynamique, une mémoire ROM effaçable programmable et une mémoire ROM programmée par masquage.

6. Dispositif de mémoire à semi-conducteur selon l'une quelconque des revendications 1 à 5, dans lequel ledit réseau de cellules de mémoire (501) comprend des cellules de mémoire pour préstocker des données fixes, et dans lequel ledit réseau de cellules redondantes (502, 503) comprend des cellules de mémoire non-volatiles programmables.

7. Dispositif de mémoire à semi-conducteur selon la revendication 6, dans lequel l'adresse défectueuse stockée dans ladite mémoire d'adresse défectueuse (504) est une partie de l'adresse de chaque cellule de mémoire défectueuse dudit réseau de cellules de mémoire (501).

8. Dispositif de mémoire à semi-conducteur selon la revendication 7, dans lequel ledit moyen de sélection (506) remplace les données extraites dudit réseau de cellules de mémoire (501) par les données d'au moins une d'une rangée et d'une colonne correspondante dudit réseau de cellules redondantes (502, 503) lorsque l'adresse défectueuse s'étend sur deux rangées ou colonnes adjacentes dudit réseau de cellules de mémoire (501) et le signal de discrimination est reçu à partir dudit moyen de discrimination (522, 523, 531), et dans lequel les adresses qui sont fournies par ladite mémoire d'adresse défectueuse (504) et lesdits moyens d'addition (531) désignent respectivement un bloc, chaque bloc étant constitué d'un ou d'une pluralité de rangées ou de colonnes dudit réseau de cellules de mémoire (501).
